Europäisches Patentamt

European Patent Office

Office européen des brevets

(11) Numéro de publication : **0 025 377**
**B1**

(12) # FASCICULE DE BREVET EUROPÉEN

(45) Date de publication du fascicule du brevet :
**20.04.83**

(51) Int. Cl.³ : **G 06 G 7/184**, G 11 C 27/02

(21) Numéro de dépôt : **80401186.4**

(22) Date de dépôt : **13.08.80**

(54) **Dispositif de commutation d'un condensateur de stockage, intégrateur et échantillonneur comportant un tel dispositif.**

(30) Priorité : **10.09.79 FR 7922585**

(43) Date de publication de la demande :
**18.03.81 Bulletin 81/11**

(45) Mention de la délivrance du brevet :
**20.04.83 Bulletin 83/16**

(84) Etats contractants désignés :
**DE GB NL**

(56) Documents cités :
**US A 3 231 728**
**US A 3 503 049**

(73) Titulaire : **THOMSON-CSF**
**173, Boulevard Haussmann**
**F-75379 Paris Cedex 08 (FR)**

(72) Inventeur : **Ricodeau, Jean**
**THOMSON-CSF SCPI 173, bld Haussmann**
**F-75360 Paris Cedex 08 (FR)**
Inventeur : **Roziere, Guy**
**THOMSON-CSF SCPI 173, bld Haussmann**
**F-75360 Paris Cedex 08 (FR)**

(74) Mandataire : **Benichou, Robert et al**
**THOMSON-CSF SCPI 173 bld Haussmann**
**F-75379 Paris Cedex 08 (FR)**

Dispositif de commutation d'un condensateur de stockage, intégrateur et échantillonneur comportant un tel dispositif.

La présente invention concerne un dispositif de commutation d'un condensateur de stockage. Elle concerne également les intégrateurs et les échantillonneurs comportant un tel dispositif.

Lorsqu'on effectue des mesures en électronique, on utilise souvent un condensateur de stockage des charges. C'est le cas, par exemple, dans les intégrateurs qui comportent généralement un amplificateur opérationnel, dont l'entrée positive est à un potentiel de référence et dont l'entrée négative reçoit le signal à intégrer, un condensateur de stockage est alors relié entre l'entrée négative et la sortie de l'amplificateur. C'est le cas également dans les échantillonneurs qui comportent généralement un amplificateur opérationnel et un condensateur de stockage monté entre l'entrée de l'amplificateur qui reçoit le signal à échantillonner et la masse.

Pour les intégrateurs comme pour les échantillonneurs, il est nécessaire de prévoir un dispositif de commutation du condensateur de stockage qui assure la décharge de ce condensateur, après chaque mesure, dans le cas de l'intégrateur et qui assure la charge de ce condensateur, lors de la prise de chaque échantillon, dans le cas de l'échantillonneur.

Le dispositif de commutation du condensateur de stockage est généralement constitué par une porte analogique de commutation en série avec une résistance. Ce dispositif est monté en parallèle sur le condensateur de stockage dans le cas de l'intégrateur et en série avec le condensateur de stockage dans le cas de l'échantillonneur.

La porte analogique est dite ouverte lorsqu'elle introduit une résistance sensiblement nulle dans le circuit où elle se trouve placée (et fermée lorsqu'elle introduit une résistance infinie).

Dans certains domaines, en électronique médicale par exemple (ainsi en scintigraphie ou en tomographie assistée par ordinateur), dans le domaine nucléaire également, il faut réaliser des mesures très rapprochées dans le temps, avec une grande précision.

Les conditions d'opération sont alors à la limite des performances des amplificateurs opérationnels et il faut tenir compte du bruit introduit par ces amplificateurs.

Ainsi, si on prend pour exemple le cas de l'intégrateur.

Après chaque mesure, la tension aux bornes du condensateur de stockage revient à zéro, en partant d'une valeur $V_0$, en suivant la décroissance exponentielle : $V(t) = V_0 \cdot e^{-t/RC}$, où R est la valeur de la résistance du dispositif de commutation et C la capacité du condensateur de stockage.

L'erreur $\Delta V$ sur la mesure suivante est constituée par la tension qui reste aux bornes du condensateur au bout du temps $T_Z$ de remise à zéro de l'intégrateur. Si on s'impose une erreur maximale $\Delta V$, le temps $T_Z$ de remise à zéro devra être tel que :

$$T_Z \geqslant RC \cdot Ln\ V_0/\Delta V \qquad (1).$$

On constate donc que pour effectuer des mesures très rapprochées dans le temps avec une erreur $\Delta V$ donnée, la valeur de R doit être minimale (la valeur de C étant imposée par la mesure).

Si on tient compte maintenant du bruit introduit par l'amplificateur opérationnel, l'erreur sur la mesure suivante qui est due à ce bruit, en fin de remise à zéro, s'écrit :

$$V_B = V_b / \sqrt{2RC} \qquad (2),$$

où $V_b$ est la densité de bruit imposée par l'amplificateur.

On constate donc que pour diminuer l'erreur due au bruit la valeur de R doit être maximale.

Les conclusions tirées des équations (1) et (2) quant à la valeur de R vont donc en sens inverse.

Il est possible de trouver la résistance optimale pour que l'erreur totale (due à la décharge incomplète et au bruit) soit minimale pour une valeur de l'erreur due à la décharge incomplète $\Delta V$ donnée. L'inconvénient est que cette résistance optimale impose le temps de remise à zéro

$$T_Z \geqslant V_b2/2\Delta V^2 \cdot Ln\ V_0/\Delta V$$

qui varie en sens inverse à $\Delta V$ et qui est souvent considéré comme trop important.

En fait, le problème qui se pose avec les intégrateurs comme avec les échantillonneurs est que la rapidité de fonctionnement demande une bande passante élevée et que la diminution du bruit demande une faible bande passante.

Lorsqu'on utilise un dispositif de commutation selon l'art antérieur qui comporte une seule porte, on ne dispose que d'une seule constante de temps RC et d'une seule bande passante et il n'est pas possible d'obtenir à la fois des mesures très rapprochées dans le temps et une grande précision.

La présente invention permet de résoudre ce problème.

Le dispositif de commutation selon l'invention comporte n circuits, constitués par une porte analogique de commutation en série avec une résistance, qui sont montés en parallèle. Le condensateur de stockage est commuté en n étapes par commutation des portes analogiques qui assurent l'augmentation d'une étape à la suivante de la résistance équivalente au dispositif.

Le dispositif selon l'invention permet d'obtenir simplement, à la fois des mesures très rapprochées dans le temps et une grande précision.

D'autres objets, caractéristiques et résultats de l'invention ressortiront de la description suivante donnée à titre d'exemple non limitatif et illustrée par les figures annexées qui représentent :

les figures 1 et 2, un intégrateur et un échantillonneur comportant un dispositif de commutation selon l'invention ;

les figures 3a à e et 4a à c, des diagrammes de signaux de commande susceptibles d'être appliqués aux portes des figures 1 et 2.

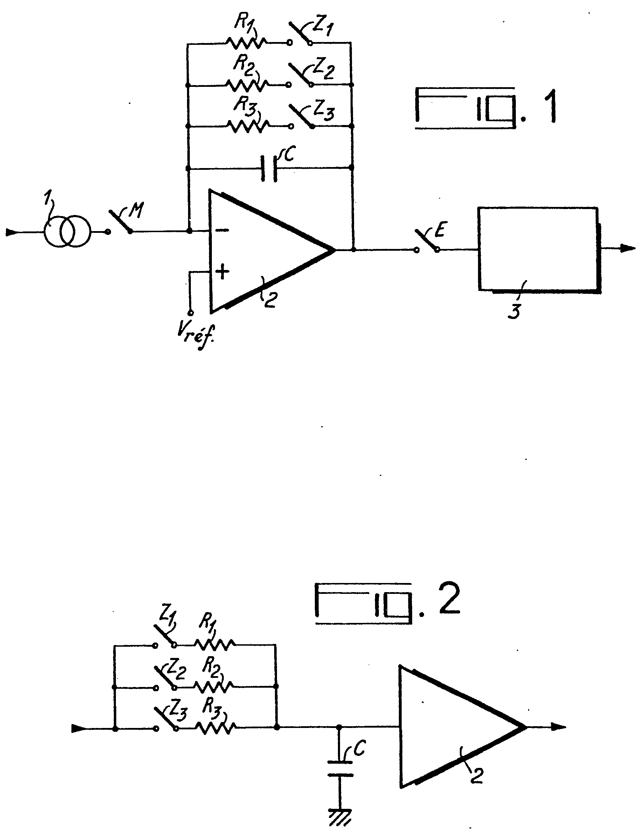

Sur les différentes figures, les mêmes repères désignent les mêmes éléments. La figure 1 représente un intégrateur comportant un dispositif de commutation selon l'invention. Cet intégrateur est constitué par un amplificateur opérationnel 2 dont l'entrée positive est portée à une tension de référence $V_{ref}$ et dont l'entrée négative reçoit le courant à mesurer. Un condensateur de stockage C est monté entre l'entrée négative et la sortie de l'amplificateur. En parallèle sur ce condensateur, on trouve un dispositif de commutation du condensateur de stockage selon l'invention. Ce dispositif est constitué par trois circuits, montés en parallèle, et comportant une résistance $R_1$, $R_2$, $R_3$ en série avec une porte analogique de commutation $Z_1$, $Z_2$, $Z_3$. Le nombre n de circuits ainsi montés en parallèle peut être quelconque ; dans la pratique, il est généralement égal à deux ou trois. Les circuits qui commandent la commutation des portes analogiques, c'est-à-dire leur passage de l'état ouvert à l'état fermé et vice-versa sont bien connus de l'art antérieur et ne sont pas représentés sur les figures. L'intégrateur ainsi réalisé peut aussi être utilisé comme préamplificateur.

Avant l'intégrateur, on trouve la source du courant à mesurer, représentée symboliquement et repérée par 1, qui est suivie par une porte de commutation M. Après l'intégrateur on trouve une porte analogique E suivie par un dispositif d'échantillonnage représenté symboliquement par un rectangle 3.

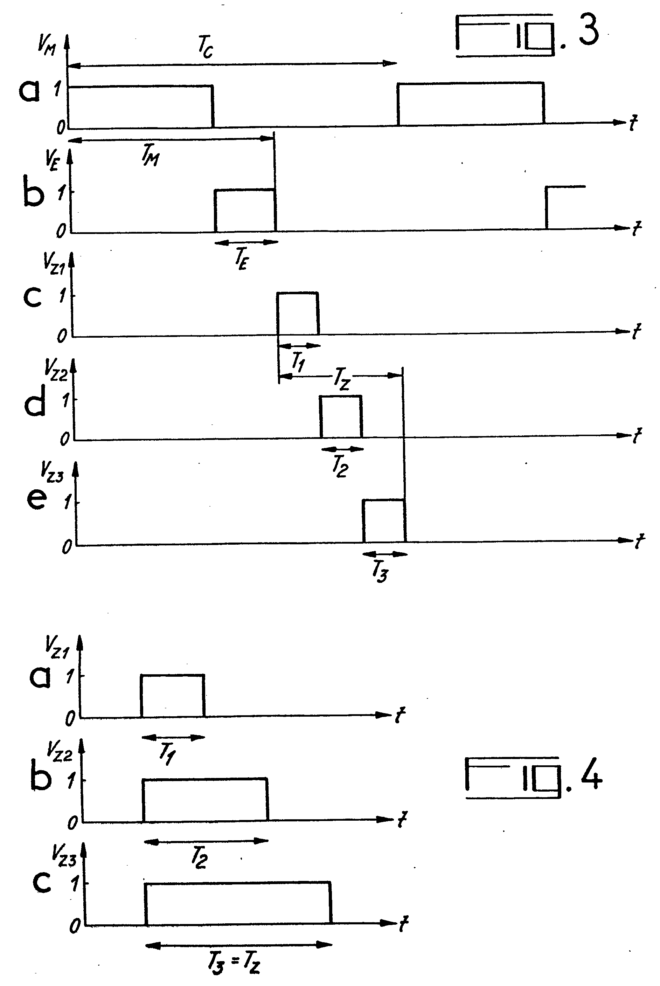

Les figures 3a à e représentent des diagrammes de signaux de commande $V_M$, $V_E$, $V_{Z1}$, $V_{Z2}$ et $V_{Z3}$ qui sont susceptibles d'être appliqués aux portes M, E, $Z_1$, $Z_2$ et $Z_3$ de la figure 1. Ces signaux de commande sont des signaux périodiques, de même période $T_C$, qui correspond au temps mis pour effectuer une mesure. Ces signaux sont soit à un niveau bas (niveau 0), soit à un niveau haut (niveau 1). Le passage d'un signal de commande au niveau haut provoque l'ouverture de la porte à laquelle il est appliqué. Les signaux $V_M$, $V_E$, $V_{Z1}$, $V_{Z2}$ et $V_{Z3}$ sont successivement au niveau haut. Pour des raisons de clarté, les durées relatives de maintien au niveau haut des signaux n'ont pas été respectées.

Pour effectuer chaque mesure, la porte M est d'abord la seule ouverte, ce qui permet l'intégration par le condensateur C du signal à mesurer. La porte M est ensuite fermée et la porte E ouverte pendant un temps $T_E$, ce qui permet l'échantillonnage du signal mesuré. On effectue ensuite la remise à zéro, c'est-à-dire la décharge, du condensateur C avant le début d'une nouvelle mesure. Avec le dispositif de commutation du condensateur stockage qui est représenté sur la figure 1, cette remise à zéro se fait en trois étapes. Au cours de chaque étape, une seule porte analogique est ouverte selon l'ordre croissant des résistances en série avec les portes. C'est-à-dire que si l'on suppose que les résistances $R_1$, $R_2$ et $R_3$ ont des valeurs croissantes, la porte $Z_1$ est d'abord la seule ouverte pendant un temps $T_1$, la porte $Z_1$ étant fermée c'est ensuite la porte $Z_2$ qui est ouverte pendant un temps $T_2$, et enfin la porte $Z_2$ étant fermée c'est la porte $Z_3$ qui est ouverte pendant un temps $T_3$. La somme des temps $T_1$, $T_2$ et $T_3$ est égale au temps $T_Z$ de remise à zéro du condensateur de stockage C.

Lorsque le dispositif de commutation comporte n circuits, constitués par une résistance en série avec une porte analogique, la commutation du condensateur se fait en n étape en ouvrant à chaque étape une seule porte analogique selon l'ordre croissant des résistances en série avec les portes.

Le dispositif de commutation selon l'invention comporte plusieurs portes analogiques et on dispose donc de plusieurs constantes de temps $R_i C_i$ ($1 \leqslant i \leqslant n$) et de plusieurs bandes passantes. Le condensateur de stockage est commuté en un nombre d'étapes égal au nombre de portes analogiques par commutation de ces portes et avec augmentation d'une étape à la suivante de la résistance équivalente au dispositif de commutation. Ainsi, au début de la remise à zéro, la constante de temps est faible et la bande passante large, ce qui permet une décharge rapide du condensateur de stockage. Par contre, à la fin de la remise à zéro, la constante de temps est importante et la bande passante étroite ce qui permet la diminution du bruit dû à l'amplificateur opérationnel et l'augmentation et la précision de la mesure. Par rapport au dispositif de commutation selon l'art antérieur, le dispositif selon l'invention permet pour un temps de remise à zéro $T_Z$ donné, d'augmenter la précision sur la mesure ou bien pour une précision sur la mesure donnée, de diminuer le temps de remise à zéro.

La commutation des portes analogiques lors de la remise à zéro peut également se faire en ouvrant toutes les portes lors de la première étape et en fermant ensuite à chaque étape l'une des portes selon l'ordre croissant des résistances en série avec les portes. Dans ce cas, les valeurs de résistance $R_i$ qui sont choisies pour optimiser la remise à zéro sont légèrement différentes de celles choisies lorsqu'on ouvre à chaque étape une seule porte analogique. Dans le cas de la figure 1 et si on suppose toujours que les résistances $R_1$, $R_2$ et $R_3$ ont des valeurs croissantes, la remise à zéro se fait en trois étapes : lors de la première étape, les portes $Z_1$, $Z_2$ et $Z_3$ sont ouvertes. Lors de la seconde étape, la porte $Z_1$ est fermée. Lors de la troisième étape enfin, les portes $Z_1$ et $Z_2$ sont fermées et seule la porte $Z_3$ est ouverte. A la fin de la troisième étape, on ferme la porte $Z_3$. On considère donc que le condensateur de stockage est déchargé et que sa commutation est terminée. Les figures 4a à c représentent des diagrammes de signaux susceptibles d'être appliqués aux portes $Z_1$, $Z_2$ et $Z_3$ de la figure 1 lorsque la commutation des portes analogiques se fait de la façon précédemment décrite. Dans ce cas, les signaux $V_{Z1}$, $V_{Z2}$ et $V_{Z3}$ passent au niveau haut au même instant, au début de la remise à zéro, mais le signal $V_{Z1}$ passe au niveau bas au bout d'un temps $T_1$ correspondant à la durée de la première étape, le signal $V_{Z2}$ passe au niveau bas au bout d'un temps $T_2$ correspondant à la durée des deux premières étapes et le signal $V_{Z3}$ passe au niveau bas au bout d'un temps $T_3$ qui est égal au temps $T_z$ de la remise à zéro totale.

Le fonctionnement de l'ensemble représenté sur la figure 1 n'est donné qu'à titre d'exemple. En particulier la porte M peut être laissée ouverte pendant un temps $T_M$, qui correspond à la mesure proprement dite et à l'échantillonnage réalisé sur cette mesure. A la limite, la porte M peut même être laissée en permanence ouverte.

La figure 2 représente un échantillonneur comportant un dispositif de commutation selon l'invention. Cet échantillonneur est constitué par un amplificateur opérationnel 2 et un condensateur de stockage C monté entre l'entrée de l'amplificateur qui reçoit le signal à échantillonner et la masse. Le signal à échantillonner est fourni à l'amplificateur par l'intermédiaire d'un dispositif de commutation du condensateur de stockage selon l'invention. Sur la figure 2, ce dispositif de commutation est, comme sur la figure 1, constitué par trois circuits montés en parallèle et constitués par une porte analogique $Z_1$, $Z_2$ et $Z_3$ en série avec une résistance $R_1$, $R_2$ et $R_3$. Les signaux de commande $V_{Z1}$, $V_{Z2}$ et $V_{Z3}$ qui sont représentés sur les figures 3c, d, e et 4a, b, c peuvent être appliqués aux portes $Z_1$, $Z_2$ et $Z_3$ pour assurer la commutation du condensateur C, c'est-à-dire sa charge lors de la prise d'un échantillon. Comme dans le cas de la figure 1, dans le cas de la figure 2, le dispositif de commutation selon l'invention permet de commencer la commutation du condensateur C avec une faible constante de temps et permet de terminer cette commutation avec une grande constante de temps. Ainsi le début de la commutation permet d'accroître la rapidité de la mesure et la fin de la commutation permet de diminuer le bruit dû à l'amplificateur opérationnel. Il est donc ainsi possible d'obtenir à la fois des mesures très rapprochées dans le temps et une grande précision.

Il est bien entendu aussi possible d'associer dans le même circuit de mesure un intégrateur tel que celui représenté sur la figure 1 et un échantillonneur tel que représenté sur la figure 2.

Le dispositif de l'invention s'applique bien entendu à tous les circuits qui comportent un condensateur de stockage à commuter, c'est-à-dire à charger ou à décharger, et pas seulement aux intégrateurs et aux échantillonneurs.

**Revendications**

1. Dispositif de commutation d'un condensateur de stockage, assurant la charge ou la décharge d'un condensateur de stockage monté respectivement en série ou en parallèle avec ce dispositif, caractérisé en ce qu'il comporte, montés en parallèle, n circuits constitués par une porte analogique de commutation en série avec une résistance, et en ce que le condensateur de stockage est commuté en n étapes par commutation des portes analogiques qui assurent l'augmentation d'une étape à la suivante de la résistance équivalente au dispositif.

2. Dispositif selon la revendication 1, caractérisé en ce qu'une seule porte analogique est ouverte à chaque étape selon l'ordre croissant des résistances en série avec les portes.

3. Dispositif selon la revendication 1, caractérisé en ce qu'à la première étape toutes les portes sont ouvertes, en ce que l'une des portes est ensuite fermée à chaque étape selon l'ordre croissant des résistances en série avec les portes.

4. Dispositif selon l'une des revendications 1 à 3, caractérisé en ce que n égale deux ou trois.

5. Intégrateur constitué par un amplificateur opérationnel et un condensateur de stockage disposé entre l'entrée négative et la sortie de l'amplificateur, caractérisé en ce qu'il comporte un dispositif de commutation selon l'une des revendications 1 à 4 monté en parallèle sur le condensateur de stockage.

6. Echantillonneur constitué par un amplificateur opérationnel et par un condensateur de stockage monté entre une entrée de l'amplificateur et la masse, caractérisé en ce qu'il comporte un dispositif de commutation selon l'une des revendications 1 à 4 en série avec le condensateur de stockage.

**Claims**

1. Device for switching a storage capacitor, assuring charging or discharging of a storage capacitor mounted in series with or parallel to this device, respectively, characterized in that it comprises n circuits connected in parallel and formed by an analog gate in series with a resistor, and in that the storage capacitor is switched through n steps by switching of the analog gates which assure the increase of the equivalent resistance in the device from one step to the following.

2. Device in accordance with claim 1, characterized in that a single analog gate is open at each step in the increasing order of the resistors which are in series with these gates.

3. Device in accordance with claim 1, characterized in that all of the gates are open at the first step and in that one of the gates is then closed at each step in the increasing order of the resistors which are in series with the gates.

4. Device in accordance with any of claims 1 to 3, characterized in that n equals two or three.

5. Integrator formed by an operational amplifier and a storage capacitor connected between the negative input and the output of the amplifier, characterized in that it comprises a switching device in accordance with any of claims 1 to 4, mounted in parallel with the storage capacitor.

6. Sampling circuit formed by an operational amplifier and a storage capacitor connected between one input of the amplifier and ground, characterized in that it comprises a switching device in accordance with any of claims 1 to 4 in series with the storage capacitor.

**Ansprüche**

1. Vorrichtung zur Umschaltung eines Speicherkonsators, für das Aufladen oder Entladen eines Speicherkondensators, der in Reihe mit oder parallel zu dieser Vorrichtung geschaltet ist, dadurch gekennzeichnet, daß sie zueinander parallelgeschaltet n Schaltungskreise umfaßt, die gebildet sind aus einem Analogschalter in Reihe mit einem Widerstand, und daß der Speicherkondensator in n Stufen umgeschaltet wird durch Umschalten der Analogschalter, die von einer Stufe zur nächsten eine Zunahme des äquivalenten Widerstandes in der Vorrichtung gewährleisten.

2. Vorrichtung nach Anspruch 1, dadurch gekennzeichnet, daß auf jeder Stufe in zunehmender Reihenfolge der in Reihe mit den Schaltern liegenden Widerstände nur eine Analogschalter durchgängig ist.

3. Vorrichtung nach Anspruch 1, dadurch gekennzeichnet, daß auf der ersten Stufe alle Schalter durchgängig sind und daß anschließend auf jeder Stufe in der zunehmenden Reihenfolge der mit den Schaltern in Reihe liegenden Widerstände einer der Schalter sperrt.

4. Vorrichtung nach einem der Ansprüche 1 bis 3, dadurch gekennzeichnet, daß n gleich zwei oder drei ist.

5. Integrator, der gebildet ist aus einem Operationsverstärker und einem Speicherkondensator, der zwischen dem negativen Eingang und dem Ausgang des Verstärkers angeordnet ist, dadurch gekennzeichnet, daß er eine Umschaltvorrichtung nach einem der Ansprüche 1 bis 4 umfaßt, die parallel zu dem Speicherkondensator geschaltet ist.

6. Abtastschaltung, die gebildet ist aus einem Operationsverstärker und einem Speicherkondensator, der zwischen einen Eingang des Verstärkers und Masse geschaltet ist, dadurch gekennzeichnet, daß sie eine Umschaltvorrichtung nach einem der Ansprüche 1 bis 4 in Reihe mit dem Speicherkondensator umfaßt.

FIG. 1

FIG. 2

FIG. 3

FIG. 4

2